# FASCICULE DE BREVET EUROPEEN

(11) **EP 2 782 774 B1**
(45) Date de publication et mention de la délivrance du brevet: **06.03.2019**
(21) Numéro de dépôt: 12788212.4
(22) Date de dépôt: 20.11.2012
(51) Int. Cl.: B60L 3/00, B60L 15/00

(54) **DISPOSITIF DE PROTECTION OPUR CONNECTEUR ELECTRIQUE D'UN MODULE D'ELECTRONIQUE DE PUISSANCE**
SCHÜTZENDE VORRICHTUNG FÜR EINEN ELEKTRISCHEN VERBINDER EINES LEISTUNGSELEKTRONIKMODULS
PROTECTIVE DEVICE FOR AN ELECTRICAL CONNECTOR OF A POWER ELECTRONICS MODULE

(30) Priorité: 25.11.2011 FR 1160825
(43) Date de publication de la demande: 01.10.2014
(73) Titulaire: Renault SAS, 92100 Boulogne Billancourt (FR)
(72) Inventeur: BOUGEARD, Stephan, F-78190 Trappes (FR)
(74) Mandataire: Rougemont, Bernard
(86) Numéro de dépôt international: PCT/EP2012/073129
(87) Numéro de publication internationale: WO 2013/076093

(56) Documents cités:
- EP-A2- 0 838 982
- DE-A1-102009 032 172
- DE-U1- 29 618 524
- US-A1- 2009 095 557
- US-B2- 7 484 581

## Description

La présente invention se rapporte de manière générale au domaine de la mécanique et plus précisément à un dispositif de protection contre les chocs d'un connecteur électrique destiné à alimenter en haute tension un groupe motopropulseur électrique.

En effet les véhicules automobiles classiques c'est-à-dire thermiques disposent de divers dispositifs de sécurité permettant de limiter les risques pour le conducteur et ses passagers en cas de chocs. Les véhicules électriques, moins courus, bénéficient des mêmes dispositifs mais nécessitent également d'autres mécanismes de protection, notamment contre les risques électriques en cas de chocs. Les connecteurs des lignes d'alimentation haute tension du groupe motopropulseur électrique d'un tel véhicule doivent notamment être protégés.

Le brevet US 7,484,581 divulgue un mécanisme de protection d'un tel connecteur en cas de choc. Ce mécanisme consiste en des bras supports permettant de fixer au châssis d'un véhicule électrique à la fois l'onduleur alimentant son groupe motopropulseur, et le connecteur électrique de l'onduleur. Ainsi en cas de choc, la déformation du châssis entraîne un mouvement de translation identique pour l'onduleur et son connecteur. La ligne haute tension en sortie de l'onduleur n'est ainsi pas déconnectée de l'onduleur, limitant les risques électriques pour le conducteur du véhicule et ses passagers.

Cependant ce mécanisme de protection n'est pas assez résistant en cas de choc frontal violent sur le véhicule, notamment si l'onduleur est intégré sur le bloc moteur du véhicule, puisque le poids de ce bloc moteur le ferait reculer indépendamment de la déformation du châssis si un tel choc frontal se présentait. Ce mécanisme de protection ne permet donc pas de flexibilité en termes d'architecture du véhicule électrique, l'onduleur devant être accroché au châssis pour que ce mécanisme fonctionne. Cette contrainte est notamment gênante lorsque l'on veut limiter l'encombrement des modules d'électronique de puissance associés au groupe motopropulseur du véhicule.

Un des buts de l'invention est de remédier à au moins une partie des inconvénients de la technique antérieure en fournissant un dispositif de protection pour connecteur électrique d'un module d'électronique de puissance, ainsi qu'un groupe motopropulseur équipé d'un tel dispositif, qui permettent de protéger efficacement ce connecteur en cas de choc frontal violent.

A cette fin, l'invention propose un dispositif de protection pour connecteur électrique d'un module d'électronique de puissance inséré dans un carter, ledit connecteur faisant saillie sur une des faces dudit carter et étant apte à connecter une ligne d'alimentation électrique audit module, caractérisé en ce que ledit dispositif comporte au moins une face apte à recouvrir au moins partiellement ledit connecteur de manière à protéger , ou comprendre, ledit connecteur entre ladite face dudit carter et ladite au moins une face du dispositif, ledit dispositif étant apte à prendre appui sur ledit carter lorsqu'une force est exercée en direction du carter sur ladite au moins une face du dispositif.

Grâce à l'invention, un module d'électronique de puissance d'un véhicule par exemple peut être intégré au bloc moteur sans avoir à être fixé à son châssis, tout en ayant son ou ses connecteurs électriques protégés en cas de choc. Notamment, en supposant par exemple que ces connecteurs électriques soient positionnés vers l'avant du véhicule, et soient protégés par le dispositif de protection selon l'invention, alors en cas de choc frontal, ladite au moins une face du dispositif de protection recevant ce choc vient prendre appui directement sur le carter du module de puissance. Les connecteurs électriques reculent donc en même temps que le bloc moteur sans être endommagés.

Ledit module bénéficiant du dispositif de protection selon l'invention est par exemple un module d'électronique de puissance d'un groupe motopropulseur électrique d'un véhicule et ladite ligne d'alimentation est un bus d'alimentation haute tension dudit groupe motopropulseur.

Il est en effet souhaitable de protéger en priorité les connecteurs haute tension des véhicules électriques.

Selon une caractéristique avantageuse de l'invention, le dispositif selon l'invention comporte un évidement destiné à permettre audit bus d'alimentation haute tension de sortir dudit connecteur dans une direction orthogonale à ladite force.

Ainsi le dispositif protège le connecteur électrique tout en permettant au bus d'alimentation de sortir du dispositif dans une direction qui ne risque pas d'endommager ce bus en cas de choc.

Selon une autre caractéristique avantageuse, le dispositif selon l'invention comporte une face supplémentaire orthogonale à ladite au moins une face dudit dispositif, ladite face supplémentaire comportant au moins :
- une première surface d'appui sur ladite face dudit carter comportant le connecteur,
- et une seconde surface apte à être fixée sur une face dudit carter latérale par rapport à ladite face dudit carter comportant ledit connecteur, ladite seconde surface faisant saillie sur ladite face supplémentaire par rapport à ladite première surface.

Cette caractéristique permet de fixer le dispositif de protection au carter, par exemple au moyen de trous et de vis situées sur la seconde surface, en des endroits qui sont derrière la première surface d'appui et donc protégés lors d'un choc frontal, ce qui permet aux fixations de ne pas casser lors de ce choc.

Selon une autre caractéristique avantageuse, le dispositif selon l'invention est formé d'une seule pièce de tôle d'acier. Ainsi la fabrication du dispositif selon l'invention est simple et peu coûteuse.

Selon une autre caractéristique avantageuse, le dispositif selon l'invention comporte des profils nervurés.

Ces profils nervurés permettent de rigidifier le dispositif et de le rendre plus résistant aux chocs.

Selon une autre caractéristique avantageuse, ladite au moins une face du dispositif comprend un évidement destiné à permettre à une ligne d'alimentation basse tension d'entrer de manière sensiblement parallèle à ladite force par ladite face dudit carter supportant ledit connecteur.

Ainsi le dispositif permet de concevoir une architecture électrique de manière flexible par rapport aux problèmes d'encombrement, certains bus d'alimentation moins critiques en cas de choc pouvant être disposés à l'avant du bloc moteur.

L'invention concerne aussi un groupe motopropulseur électrique pour véhicule électrique, comportant au moins un module d'électronique de puissance protégé dans un carter, ledit carter comportant une face supportant un connecteur faisant saillie sur ladite face et apte à connecter une ligne d'alimentation électrique audit module, caractérisé en ce que ledit connecteur est protégé par le dispositif de protection selon l'invention, et en ce que ladite face dudit carter supportant ledit connecteur comporte au moins un arceau apte à permettre à ladite au moins une face du dispositif de protection de prendre appui sur ledit arceau lorsque ladite force est exercée sur ladite au moins une face du dispositif selon l'invention.

L'arceau sur le carter permet de réaliser le dispositif de protection selon l'invention avec une pièce de tôle réduite, par exemple une feuille de tôle pliée selon deux plans à 90 degrés, un des plans pouvant prendre appui sur cet arceau. En effet dans ce cas l'un des plans recouvre partiellement le connecteur tout en prenant appui sur cet arceau, tandis que l'autre plan prend appui sur le carter et permet la fixation du dispositif. Un tel dispositif de protection comportant seulement deux plans permet une fabrication simple s'affranchissant des problèmes d'intervalle de tolérance liés aux dimensions du carter. En effet le carter est souvent réalisé en deux parties, sa hauteur est donc sujette à un intervalle d'erreur gênant pour réaliser un dispositif de protection sous forme d'une tôle pliée en U par exemple.

Avantageusement, ledit arceau est une pièce moulée solidairement avec ledit carter. Cette caractéristique facilite encore la fabrication du groupe motopropulseur selon l'invention.

Selon une autre caractéristique avantageuse, ladite face dudit carter comportant ledit connecteur comporte au moins un arceau situé sous un plan horizontal délimitant ledit connecteur et ledit arceau.

Cette caractéristique permet de réaliser un dispositif de protection selon l'invention sous la forme d'une tôle pliée à 90° et positionnée sur le dessus du groupe motopropulseur. Ainsi la maintenance du groupe motopropulseur est facilitée, puisque le dispositif de protection a un encombrement limité et peut être ôté du carter sans avoir à accéder à des fixations situées sous le connecteur.

D'autres caractéristiques et avantages apparaîtront à la lecture d'un mode de réalisation préféré décrit en référence aux figures dans lesquelles :
- la figure 1 représente une vue de dessus du dispositif de protection selon l'invention dans ce mode de réalisation préféré,
- et la figure 2 représente une vue de côté du dispositif de protection selon l'invention dans ce mode de réalisation préféré.

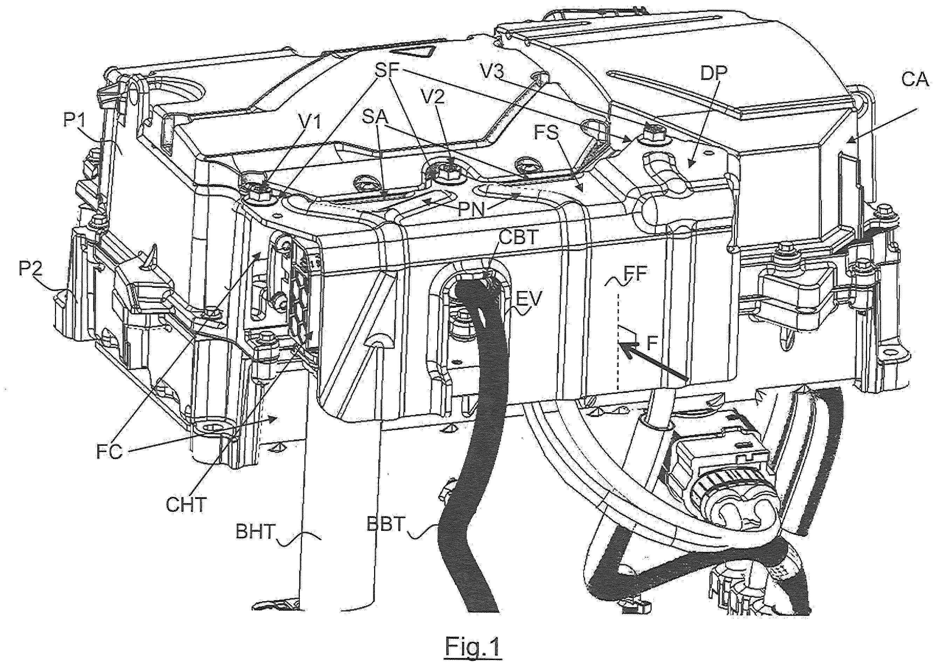

Selon un mode de réalisation préféré de l'invention représenté à la **figure 1****,** un dispositif de protection DP selon l'invention protège un connecteur électrique CHT permettant d'alimenter par un bus BHT d'alimentation haute tension, un module d'électronique de puissance, tel qu'un onduleur, inséré dans un carter CA d'un groupe motopropulseur électrique d'un véhicule.

Le carter CA est formé de deux pièces moulées en aluminium, c'est-à-dire une pièce inférieure P2 et une pièce supérieure P1, fixées entre elles au moyen de boulons. Dans ce mode de réalisation préféré selon l'invention, le carter CA enferme non seulement le module d'électronique de puissance alimenté par le connecteur électrique CHT, mais aussi d'autres modules électroniques de puissance ainsi que la machine électrique de traction du véhicule.

Le connecteur électrique CHT fait saillie sur une face avant FC du carter CA. Le bus BHT d'alimentation haute tension du module d'électronique de puissance sort du connecteur électrique CHT à la verticale et vers le bas. D'autres connecteurs électriques haute tension, ainsi qu'un connecteur électrique CBT permettant de connecter au groupe motopropulseur une ligne d'alimentation basse tension BBT reliée à un réseau d'alimentation basse tension du véhicule, font saillie sur la face FC du carter CA. Les connecteurs électriques haute tension sont protégés par le dispositif de protection DP notamment contre un choc frontal c'est-à-dire dirigé vers l'avant du véhicule, selon une force F. Le connecteur électrique base tension CBT sort du dispositif de protection DP par un évidement EV du dispositif de protection DP, dans une direction contraire à la force F. Le bus électrique BBT n'est donc pas protégé contre un choc frontal mais son connecteur électrique CBT l'est puisqu'il est situé entre la face avant FC du carter CA et une face frontale FF du dispositif de protection selon l'invention. Cette face frontale FF est sensiblement parallèle à la face avant FC du carter CA.

Il est à noter que dans cette demande, l'expression « face », sans mention contraire, désigne non seulement la paroi interne d'un plan mais aussi sa paroi externe.

Ainsi, dans ce mode de réalisation de l'invention, le dispositif de protection DP est formé d'une seule pièce de tôle d'acier pliée sensiblement à 90°, comportant deux faces, c'est-à-dire une face frontale FF et une face supplémentaire latérale FS. Cette pièce de tôle est réalisée en tôle emboutie de 3 millimètres d'épaisseur environ.

Elle est fixée au carter CA latéralement par rapport à la face avant FC du carter, par trois vis V1, V2 et V3 de 8 millimètres de diamètre, au niveau de surfaces de fixation SF faisant saillie sur la face supplémentaire latérale FS par rapport à des surfaces d'appui SA en contact avec la face avant FC du carter. Ces surfaces d'appui SA de la face supplémentaire latérale FS, aussi appelées « antibursts », sont situées dans un plan horizontal inférieur à celui des surfaces de fixation SF. En effet la pièce de tôle formant le dispositif de protection DP est travaillée de manière à ce que les surfaces de fixation SF se positionnent sur le dessus du carter tandis que les surfaces d'appui SA sont en contact avec le bord supérieur de la face avant FC du carter. Cela permet, en cas de choc frontal, de protéger les vis de fixation V1, V2 et V3 et donc d'empêcher le dispositif de protection DP de glisser vers le carter.

En variante, d'autres moyens de fixation sont envisageables à la place des vis V1, V2 et V3, tels que des soudures ou des goujons avec des écrous.

Le dispositif de protection DP comporte également des profils nervurés PN destinés à rigidifier l'ensemble. Leur disposition sur la surface supplémentaire latérale FS permet notamment de protéger efficacement les vis V1, V2 et V3 contre les chocs frontaux, en plus de l'action des « antibursts » constitués par les surfaces d'appui SA. Ces profils nervurés peuvent par exemple être obtenus par gaufrage.

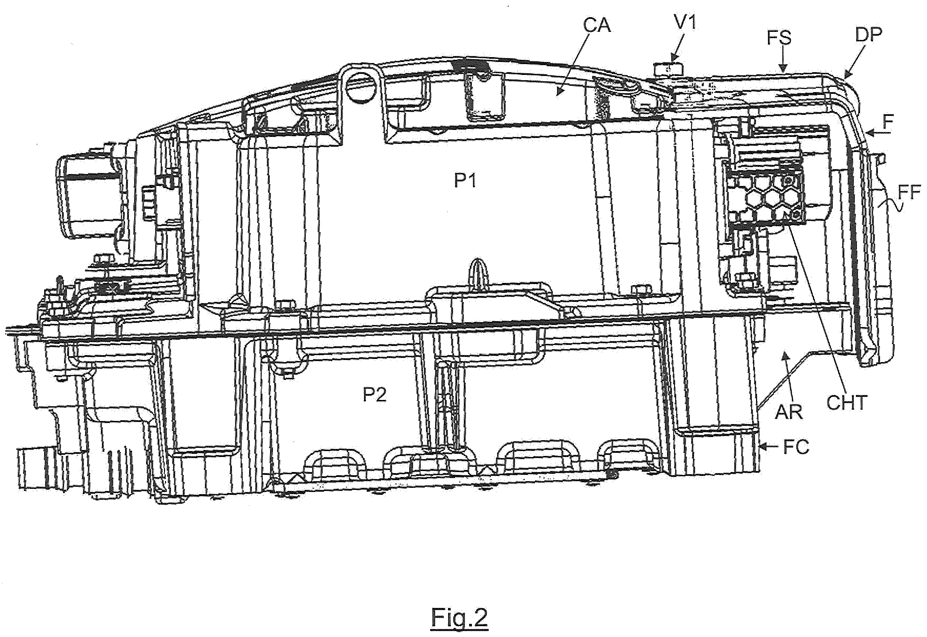

La protection contre un choc frontal des connecteurs électriques sortant du carter est assurée par le dispositif de protection DP qui prend appui sur le carter en réaction à la force F, et non sur les connecteurs. Les points d'appui sont situés, dans ce mode de réalisation de l'invention :
- au niveau des surfaces d'appui SA sur le bord supérieur de la face avant FC du carter
- ainsi qu'au niveau d'arceaux AR visibles sur la **figure 2****,** qui prolongent la face avant FC du carter CA au-delà des connecteurs électriques. Ces arceaux AR sont moulés solidairement avec la pièce P2 en aluminium du carter.

Les bus d'alimentation électriques haute tension peuvent passer librement entre les arceaux AR du carter CA, verticalement et vers le bas, ce qui leur évite d'être sectionnés en cas de choc frontal.

Grâce à l'invention, les connecteurs électriques haute tension du groupe motopropulseur sont donc efficacement protégés contre un choc frontal. De plus le dispositif de protection est peu encombrant : il suffit de dévisser les trois vis V1, V2 et V3 pour ôter le dispositif de protection DP du carter CA, ce qui facilite la maintenance du groupe motopropulseur électrique.

Il est à noter que bien que dans ce mode de réalisation préféré de l'invention, on utilise plusieurs arceaux et plusieurs « antibursts », des variantes de réalisation sont envisageables, utilisant par exemple un seul « antiburst » et un seul arceau centraux. D'autres modes de réalisation sont également possibles, dans lesquels par exemple le carter comporte des arceaux sur les deux pièces moulées P1 et P2, auquel cas le dispositif de protection selon l'invention se limiterait à une pièce d'une seule face, ou au contraire dans lesquels le dispositif de protection formerait un couvercle formé d'une face frontale et de deux faces latérales prenant chacune appui sur le carter, ces faces latérales pouvant être éventuellement minimisées sous la forme de pieds d'appui. De plus, le dispositif de protection selon l'invention n'est pas nécessairement réalisé en tôle d'acier emboutie. Il est possible de le mouler solidairement des pièces P1 et P2. Dans ce dernier cas il serait formé de deux pièces réunies pour former le carter et son dispositif de protection de connecteur électrique.

## Revendications

1. Dispositif de protection (DP) pour connecteur électrique (CHT) d'un module d'électronique de puissance inséré dans un carter (CA), ledit connecteur (CHT) faisant saillie sur une des faces (FC) dudit carter (CA) et étant apte à connecter une ligne d'alimentation électrique (BHT) audit module, ledit dispositif (DP) comportant au moins une face (FF) apte à recouvrir au moins partiellement ledit connecteur (CHT) de manière à protéger ledit connecteur (CHT) entre ladite face (FC) dudit carter (CA) et ladite au moins une face (FF) du dispositif (DP), ledit dispositif (DP) étant apte à prendre appui sur ledit carter (CA) lorsqu'une force (F) est exercée en direction du carter (CA) sur ladite au moins une face (FF) du dispositif (DP), ledit dispositif étant **caractérisé en ce que** ledit module est un module d'électronique de puissance d'un groupe motopropulseur électrique d'un véhicule et ladite ligne d'alimentation (BHT) est un bus d'alimentation haute tension dudit groupe motopropulseur, ledit dispositif comportant un évidement destiné à permettre audit bus d'alimentation haute tension de sortir dudit connecteur (CHT) dans une direction orthogonale à ladite force (F), ledit dispositif étant formé d'une seule pièce de tôle d'acier.

2. Dispositif de protection (DP) selon la revendication 1, **caractérisé en ce qu'**il comporte une face supplémentaire (FS) orthogonale à ladite au moins une face (FF) dudit dispositif, ladite face supplémentaire (FS) comportant au moins :
- une première surface d'appui (SA) sur ladite face (FC) dudit carter (CA) comportant le connecteur (CHT),
- et une seconde surface (SF) apte à être fixée sur une face dudit carter (CA) latérale par rapport à ladite face (FC) dudit carter comportant ledit connecteur, ladite seconde surface (SF) faisant saillie sur ladite face supplémentaire (FS) par rapport à ladite première surface (SA).

3. Dispositif de protection (DP) selon la revendication 1 ou 2, **caractérisé en ce qu'**il comporte des profils nervurés (PN).

4. Dispositif de protection (DP) selon l'une quelconque des revendications 1 à 3, **caractérisé en ce que** ladite au moins une face (FF) du dispositif (DP) comprend un évidement (EV) destiné à permettre à une ligne d'alimentation basse tension (BBT) d'entrer de manière sensiblement parallèle à ladite force (F) par ladite face (FC) dudit carter (CA) supportant ledit connecteur (CHT).

5. Groupe motopropulseur électrique pour véhicule électrique, comportant au moins un module d'électronique de puissance protégé dans un carter (CA), ledit carter (CA) comportant une face (FC) supportant un connecteur (CHT) faisant saillie sur ladite face (FC) et apte à connecter une ligne d'alimentation électrique (BHT) audit module, **caractérisé en ce que** ledit connecteur (CHT) est protégé par le dispositif de protection (DP) selon l'une quelconque des revendications 1 à 4, et **en ce que** ladite face (FC) dudit carter (CA) supportant ledit connecteur (CHT) comporte au moins un arceau (AR) apte à permettre à ladite au moins une face (FF) du dispositif de protection de prendre appui sur ledit arceau (AR) lorsque ladite force (F) est exercée sur ladite au moins une face (FF) du dispositif (DP).

6. Groupe motopropulseur selon la revendication 5, **caractérisé en ce que** ledit arceau (AR) est une pièce moulée solidairement avec ledit carter (CA).

7. Groupe motopropulseur selon l'une des revendications 5 ou 6, **caractérisé en ce que** ladite face (FC) dudit carter (CA) comportant ledit connecteur (CHT) comporte au moins un arceau (AR) situé sous un plan horizontal délimitant ledit connecteur (CHT) et ledit arceau (AR).

## Patentansprüche

1. Schutzvorrichtung (DP) für einen elektrischen Verbinder (CHT) eines Leistungselektronikmoduls, das in ein Gehäuse (CA) eingesetzt ist, wobei der Verbinder (CHT) auf einer der Seiten (FC) des Gehäuses (CA) vorsteht und dafür ausgelegt ist, eine Stromversorgungsleitung (BHT) mit dem Modul zu verbinden, wobei die Vorrichtung (DP) wenigstens eine Seite (FF) aufweist, die dafür ausgelegt ist, den Verbinder (CHT) wenigstens teilweise zu überdecken, um so den Verbinder (CHT) zwischen der Seite (FC) des Gehäuses (CA) und der wenigstens einen Seite (FF) der Vorrichtung (DP) zu schützen, wobei die Vorrichtung (DP) dafür ausgelegt ist, sich auf das Gehäuse (CA) abzustützen, wenn eine Kraft (F) in Richtung des Gehäuses (CA) auf die wenigstens eine Seite (FF) der Vorrichtung (DP) ausgeübt wird, wobei die Vorrichtung **dadurch gekennzeichnet ist, dass** das Modul ein Leistungselektronikmodul eines elektrischen Antriebsstranges eines Fahrzeugs ist und die Versorgungsleitung (BHT) ein Hochspannungsversorgungsbus des Antriebsstranges ist, wobei die Vorrichtung eine Aussparung aufweist, die dazu bestimmt ist zu ermöglichen, dass der Hochspannungsversorgungsbus aus dem Verbinder (CHT) in einer Richtung austritt, die zu der Kraft (F) orthogonal ist, wobei die Vorrichtung einstückig aus einem Stahlblech ausgebildet ist.

2. Schutzvorrichtung (DP) nach Anspruch 1, **dadurch gekennzeichnet, dass** sie eine zusätzliche Seite (FS) aufweist, die zu der wenigstens einen Seite (FF) der Vorrichtung orthogonal ist, wobei die zusätzliche Seite (FS) wenigstens aufweist:
- eine erste Fläche (SA) zur Anlage an der den Verbinder (CHT) aufweisenden Seite (FC) des Gehäuses (CA),
- und eine zweite Fläche (SF), die dafür ausgelegt ist, an einer bezüglich der den Verbinder aufweisenden Seite (FC) des Gehäuses lateralen Seite des Gehäuses (CA) befestigt zu werden, wobei diese zweite Fläche (SF) auf der zusätzlichen Seite (FS) bezüglich der ersten Fläche (SA) vorsteht.

3. Schutzvorrichtung (DP) nach Anspruch 1 oder 2, **dadurch gekennzeichnet, dass** sie gerippte Profile (PN) aufweist.

4. Schutzvorrichtung (DP) nach einem der Ansprüche 1 bis 3, **dadurch gekennzeichnet, dass** die wenigstens eine Seite (FF) der Vorrichtung (DP) eine Aussparung (EV) aufweist, die dazu bestimmt ist zu ermöglichen, dass eine Niederspannungsversorgungsleitung (BBT) im Wesentlichen parallel zur Kraft (F) über die den Verbinder (CHT) tragende Seite (FC) des Gehäuses (CA) eintritt.

5. Elektrischer Antriebsstrang für ein Elektrofahrzeug, welcher wenigstens ein in einem Gehäuse (CA) geschütztes Leistungselektronikmodul aufweist, wobei das Gehäuse (CA) eine Seite (FC) aufweist, die einen Verbinder (CHT) trägt, der auf dieser Seite (FC) vorsteht und dafür ausgelegt ist, eine Stromversorgungsleitung (BHT) mit dem Modul zu verbinden, **dadurch gekennzeichnet, dass** der Verbinder (CHT) durch die Schutzvorrichtung (DP) nach einem der Ansprüche 1 bis 4 geschützt ist, und dadurch, dass die den Verbinder (CHT) tragende Seite (FC) des Gehäuses (CA) wenigstens einen Bügel (AR) aufweist, der dafür ausgelegt ist zu ermöglichen, dass sich die wenigstens eine Seite (FF) der Schutzvorrichtung auf diesen Bügel (AR) stützt, wenn die Kraft (F) auf die wenigstens eine Seite (FF) der Vorrichtung (DP) ausgeübt wird.

6. Antriebsstrang nach Anspruch 5, **dadurch gekennzeichnet, dass** der Bügel (AR) ein Formteil ist, das mit dem Gehäuse (CA) fest verbunden ist.

7. Antriebsstrang nach einem der Ansprüche 5 oder 6, **dadurch gekennzeichnet, dass** die den Verbinder (CHT) aufweisende Seite (FC) des Gehäuses (CA) wenigstens einen Bügel (AR) aufweist, der sich unter einer horizontalen Ebene befindet, die den Verbinder (CHT) und den Bügel (AR) begrenzt.

## Claims

1. Protective device (DP) for an electrical connector (CHT) of a power electronics module inserted in a casing (CA), said connector (CHT) protruding from one of the faces (FC) of said casing (CA) and being suitable to connect an electrical supply line (BHT) to said module, said device (DP) including at least one face (FF) for covering at least partially said connector (CHT) so as to protect said connector (CHT) between said face (FC) of said casing (CA) and said at least one face (FF) of the device, said device being able to bear on said casing (CA) when a force (F) is applied in the direction of the casing (CA) on said at least one face (FF) of the device (DP), said device (DP) being **characterized in that** said module is a power electronics module of an electrical power train of a vehicle and said supply line (BHT) is a high-voltage power bus of said power train, said device (DP) including a recess for allowing said high-voltage power bus to exit said connector (CHT) in a direction that is orthogonal to said force (F), said device being formed from a single piece of sheet steel.

2. Protective device (DP) according to Claim 1, **characterized in that** it includes an additional face (FS) orthogonal to said at least one face (FF) of said device, said additional face (FS) including at least:
- a first surface (SA) for bearing on said face (FC) of said casing (CA) including the connector (CHT),
- and a second surface (SF) which can be fixed on a face of said casing (CA), which is lateral to said face (FC) of said casing including said connector, said second surface (SF) protruding from said additional face (FS) in relation to said first surface (SA).

3. Protective device (DP) according to Claim 1 or 2, **characterized in that** it includes ribbed profiles (PN).

4. Protective device (DP) according to any one of Claims 1-3, **characterized in that** said at least one face (FF) of the device (DP) comprises a recess (EV) for allowing a low-voltage supply line (BBT) to enter, in a substantially parallel manner to said force (F), via said face (FC) of said casing (CA) supporting said connector (CHT).

5. Electrical power train for an electric vehicle, including at least one power electronics module protected in a casing (CA), said casing (CA) including a face (FC) supporting a connector (CHT) protruding from said face (FC) and suitable to connect an electrical supply line (BHT) to said module, **characterized in that** said connector (CHT) is protected by the protective device according to any one of Claims 1 to 4, and **in that** said face (FC) of said casing (CA) supporting said connector (CHT) includes at least one arch (AR) for allowing said at least one face (FF) of the protective device to bear on said arch (AR) when said force (F) is applied to said at least one face (FF) of the device (DP).

6. Power train according to Claim 5, **characterized in that** said arch (AR) is a piece cast in a rigidly connected manner with said casing (CA).

7. Power train according to either of Claims 5 and 6, **characterized in that** said face (FC) of said casing (CA) including said connector (CHT) includes at least one arch (AR) located under a horizontal plane defining said connector (CHT) and said arch (AR).
